(19) Europäisches Patentamt
European Patent Office
Office européen des brevets

(11) **EP 0 899 875 A2**

(12) **EUROPÄISCHE PATENTANMELDUNG**

(43) Veröffentlichungstag:
03.03.1999 Patentblatt 1999/09

(51) Int. Cl.$^6$: **H03H 11/18**

(21) Anmeldenummer: 98114687.1

(22) Anmeldetag: 05.08.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 26.08.1997 DE 19737091

(71) Anmelder:
TEMIC Semiconductor GmbH
74072 Heilbronn (DE)

(72) Erfinder: **Kling, Helmut, Dr.**
**89275 Elchingen (DE)**

(74) Vertreter:
**Maute, Hans-Jürgen, Dipl.-Ing.**
**Daimler-Benz Aktiengesellschaft,**
**FTP/H,**
**Postfach 35 35**
**74025 Heilbronn (DE)**

(54) **Integrierte Phasenschieberanordnung**

(57) Eine integrierte Phasenschieberanordnung weist in einem ersten Signalzweig ein erstes Tiefpaßfilter und ein erstes Hochpaßfilter mit gleich großen Zweitkonstanten und gleich großen Verstärkungsfaktoren auf. Das erste Tiefpaßfilter und das erste Hochpaßfilter sind eingangsseitig miteinander und ausgangsseitig mit einer Summationseinheit zu einem Allpaßfilter verbunden. Vorzugsweise weist sie in einem zweiten Signalzweig ein zweites Tiefpaßfilter und ein zweites Hochpaßfilter mit gleich großen Zweitkonstanten und gleich großen Verstärkungsfaktoren auf, die ebenfalls eingangsseitig miteinander und ausgangsseitig mit der Summationseinheit verbunden sind.

FIG. 1

**Beschreibung**

In der Schaltungstechnik werden üblicherweise Allpaßfilter zur Phasenverschiebung analoger Signale eingesetzt. Der wesentliche Nachteil eines derartigen Filters liegt in dem Abgleich der Filterparameter, der zur Gewährleistung einer frequenzunabhängigen Verstärkung erforderlichen ist und der mit erheblichem Arbeits- und Kostenaufwand verbunden ist.

Der Erfindung liegt die Aufgabe zugrunde, eine Phasenschieberanordnung anzugeben, die nicht abgeglichen werden muß und daher kostengünstig herstellbar ist.

Die Aufgabe wird durch die Merkmale des Patentanspruchs 1 gelöst. Vorteilhafte Ausgestaltungen und Weiterbildungen ergeben sich aus den Unteransprüchen.

Erfindungsgemäß weist die Phasenschieberanordnung in einem ersten Signalzweig ein erstes Tiefpaßfilter und ein erstes Hochpaßfilter auf, die auf einen gemeinsamen Halbleiterchip integriert sind und die eingangsseitig miteinander und ausgangsseitig mit einer Summationseinheit zu einem Allpaßfilter für ein dem ersten Signalzweig zugeführtes Zweigsignal verbunden sind. Um eine frequenzunabhängige Verstärkung zu gewährleisten, müssen sowohl die Zeitkonstanten als auch die Verstärkungsfaktoren des Tiefpaß- und Hochpaßfilters jeweils gleich sein. Diese Forderung ist bei auf einen gemeinsamen Halbleiterchip integrierten Filterschaltungen mit hoher Genauigkeit erfüllbar, da in einem integrierten Schaltkreis sehr genaue Widerstands- und Kapazitätsverhältnisse herstellbar sind. Ein Abgleich der Filterparameter ist daher nicht erforderlich.

In einer vorteilhaften Weiterbildung weist die Phasenschieberanordnung in einem zweiten Signalzweig ein zweites Tiefpaßfilter und ein zweites Hochpaßfilter auf, die auf das gleiche Halbleiterchip integriert sind und die ebenfalls eingangsseitig miteinander und ausgangsseitig mit der Summationseinheit zu einem Allpaßfilter, und zwar für ein dem zweiten Signalzweig zugeführtes zweites Zweigsignal, verbunden sind. Auch die Zeitkonstanten und Verstärkungsfaktoren des zweiten Tiefpaßfilters und des zweiten Hochpaßfilters müssen daher jeweils gleich sein.

Vorteilhafterweise sind zudem die Verstärkungsfaktoren der Tiefpaßfilter und der Hochpaßfilter aus beiden Signalzweigen gleich groß, so daß das erste Zweigsignal im ersten Signalzweig und das zweite Zweigsignal im zweiten Signalzweig um jeweils den gleichen Faktor verstärkt oder gedämpft werden. Um die Zweigsignale relativ zueinander in der Phase zu verschieben, werden die Zeitkonstanten der Filter aus dem ersten Signalzweig unterschiedlich von jenen der Filter aus dem zweiten Signalzweig gewählt. Sie werden insbesondere derart gewählt, daß die Differenz der Phasenverschiebung in den beiden Signalzweigen, d. h. die relative Phasenverschiebung der Zweigsignale, bei einer vorgegebenen Frequenz maximal ist und dabei einen Maximalwert annimmt, der vorzugsweise um einen vorgegebenen Phasenfehler größer ist als 90°. Ein bevorzugter Anwendungsfall der erfindungsgemäßen Phasenschieberanordnung ist dann, die Unterdrückung von Spiegelfrequenzen, die bei der Frequenzumsetzung in einem Mischer entstehen.

Die Erfindung wird im folgenden anhand von Ausführungsbeispielen unter Bezugnahme auf die Figuren näher beschrieben. Es zeigen:

Figur 1:     eine Prinzipdarstellung einer Phasenschieberanordnung mit einem Signalzweig,

Figur 2:     eine Prinzipdarstellung einer Phasenschieberanordnung mit zwei Signalzweigen,

Figur 3:     ein Diagramm der Phasendifferenz der Phasenverschiebung in den beiden Signalzweigen der Phasenschieberanordnung aus Figur 2,

Figur 4:     eine Prinzipdarstellung einer Schaltungsanordnung zur Frequenzumsetzung mit einer Phasenschieberanordnung gemäß Figur 2,

Figur 5:     ein Detailschaltbild der Phasenschieberanordnung aus Figur 2.

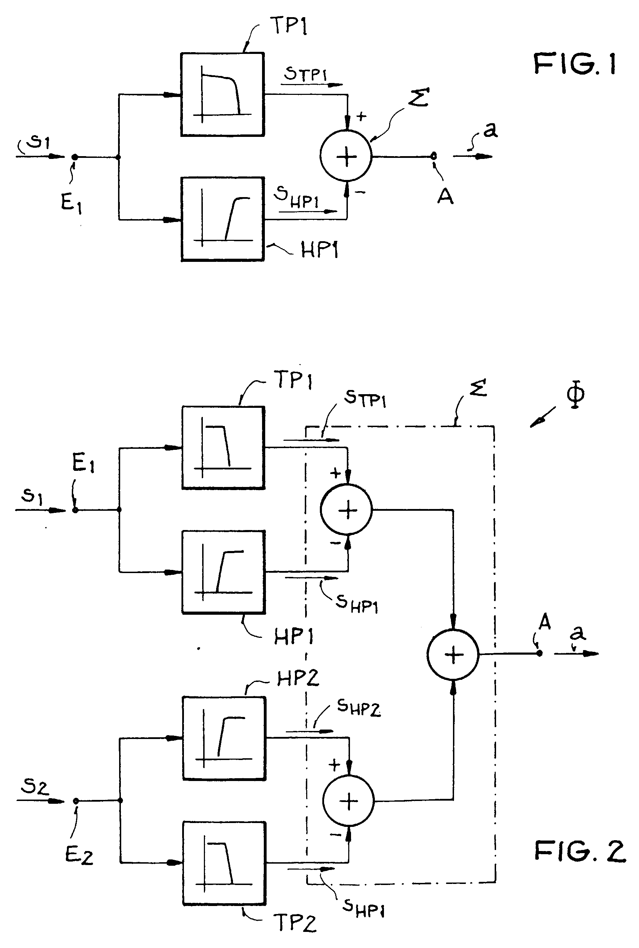

Gemäß Figur 1 wird ein erstes Zweigsignal $s_1$ dem Eingang $E_1$ eines ersten Signalzweigs zugeführt. Dieser Signalzweig weist ein erstes Tiefpaßfilter TP1 und ein erstes Hochpaßfilters HP1 auf, die eingangsseitig mit dem Ein-gang $E_1$ und ausgangsseitig mit je einem Eingang einer Summationseinheit $\Sigma$ verbunden sind, in welcher die an den Ausgängen des Tiefpaßfilters TP1 und des Hochpaßfilters HP1 anstehenden gefilterten Zweigsignale $s_{TP1}$ bzw. $s_{HP1}$ vorzeichenbehaftet und mit einem konstanten Vorfaktor $k_0$ versehen zu dem am Schaltungsausgang A anstehenden Ausgangssignal $a = k_0 (s_{TP1} - s_{HP1})$ summiert werden. Das Tiefpaßfilter TP1 und das Hochpaßfilter HP1 sind als Filter erster Ordnung aufgeführt. Ihre Übertragungsfunktionen lauten:

$$A_{TP1}(\omega) = K_{TP1} \cdot \frac{1}{1 + j \cdot \omega \cdot \tau_{TP1}}$$

bzw.

$$A_{HP1}(\omega) = K_{HP1} \cdot \frac{j \cdot \omega \cdot \tau_{HP1}}{1+j \cdot \omega \cdot \tau_{HP1}}$$

mit $\omega = 2\pi f$, wobei $K_{TP1}$, $K_{HP1}$ für die Verstärkungsfaktoren und $\tau_{TP1}$, $\tau_{HP1}$ für die Zeitkonstanten des jeweiligen Filters, j für die imaginäre Einheit, $\omega$ für die Kreisfrequenz, f für die Frequenz und $\pi$ für die Kreiszahl stehen. Für die Übertragungsfunktion des gesamten Signalzweiges erhält man dann:

$$A_1(\omega) = k_0 \cdot A_{TP1}(\omega) - k_0 \cdot A_{HP1}(\omega) = k_0 \cdot K_{TP1} \cdot \frac{1}{1+j \cdot \omega \cdot \tau_{TP1}} - k_0 \cdot K_{HP1} \cdot \frac{j \cdot \omega \cdot \tau_{HP1}}{1+j \cdot \omega \cdot \tau_{HP1}}.$$

Mit gleichen Zeitkonstanten $\tau_1 = \tau_{TP1} = \tau_{HP1}$ und gleichen Verstärkungsfaktoren $K = k_0 K_{TP1} = k_0 K_{HP1}$ gilt folglich:

$$A_1(\omega) = K \cdot \frac{1-j \cdot \omega \cdot \tau_1}{1+j \cdot \omega \cdot \tau_1}.$$

Dieses ist die Übertragungsfunktion eines Allpaßfilters mit der frequenzabhängigen Phasenverschiebung $\varphi_1(\omega) \cdot 2 \cdot \arctan(\omega \cdot \tau_1)$.

Die Schaltungsanordnung aus Figur 1 läßt sich gemäß Figur 2 zu einer Phasenschieberanordnung $\Phi$ mit zwei Signalzweigen für zwei Zweigsignale $s_1$, $s_2$ erweitern. Der erste Signalzweig entspricht der Schaltungsanordnung aus Figur 1; der zweite Signalzweig weist ein zweites Tiefpaßfilter TP2 und ein zweites Hochpaßfilter HP2 auf, die analog zum ersten Signalzweig eingangsseitig mit dem Eingang $E_2$ des zweiten Signalzweiges und ausgangsseitig mit je einem von zwei weiteren Eingängen der Summationseinheit $\Sigma$ verbunden sind. Das zweite Tiefpaßfilter TP2 und das zweite Hochpaßfilter HP2 erzeugen aus dem dem Eingang $E_2$ zugeführten zweiten Zweigsignal $s_2$ die beiden gefilterten Zweigsignale $s_{TP2}$, $s_{HP2}$, die der Summationseinheit $\Sigma$ zugeführt werden, in welcher die beiden signalzweige zusammengeführt werden. Dabei werden die gefilterten Zwischensignale $s_{TP1}$, $s_{HP1}$, $s_{TP2}$, $s_{HP2}$ aus den beiden Signalzweigen vorzeichenbehaftet und mit dem Vorfaktor $k_0$ versehen summiert, so daß für das Ausgangssignal a folgende Beziehung gilt:

$$a = k_0 (s_{TP1} - s_{HP1}) + k_0 (s_{TP2} \, s_{HP2})$$

oder

$$a = k_0 (s_{TP1} - s_{HP1}) - k_0 (s_{TP2} - s_{HP2}).$$

Die beiden Filter TP2 und HP2 des zweiten Signalzweigs unterscheiden sich von den entsprechenden Filtern TP1 bzw. HP1 aus dem ersten signalzweig lediglich in ihren Zeitkonstanten, wobei die Zeitkonstanten des zweiten Tiefpaßfilters TP2 und des zweiten Hochpaßfilters HP2 gleich sind und im folgenden mit $\tau_2$ bezeichnet werden. Die Übertragungsfunktion des zweiten Signalzweiges lautet daher:

$$A_2(\omega) = K \cdot \frac{1-j \cdot \omega \cdot \tau_2}{1+j \cdot \omega \cdot \tau_2}.$$

Dieses entspricht einer Phasenverschiebung $\varphi_2(\omega) = -2 \cdot \arctan(\omega \cdot \tau_2)$. Infolgedessen werden die Zweigsignale $s_1$, $s_2$ in der Phase relativ zueinander um die Phasendifferenz

$$\Delta\varphi(\omega) = \varphi_2(\omega) - \varphi_1(\omega) = 2 \cdot \arctan\left(\frac{\omega \cdot (\tau_1 - \tau_2)}{1 + \omega^2 \cdot \tau_1 \cdot \tau_2}\right)$$

verschoben, welche bei der Frequenz

$$f_{Max} = \frac{\omega_{Max}}{2\pi} = \frac{1}{2\pi \cdot \sqrt{\tau_1 \cdot \tau_2}}$$

ihren Maximalwert

$$\Delta\varphi_{Max} = 2 \cdot \arctan\left(\frac{1}{2} \cdot \frac{(\tau_1 - \tau_2)}{\sqrt{\tau_1 \cdot \tau_2}}\right)$$

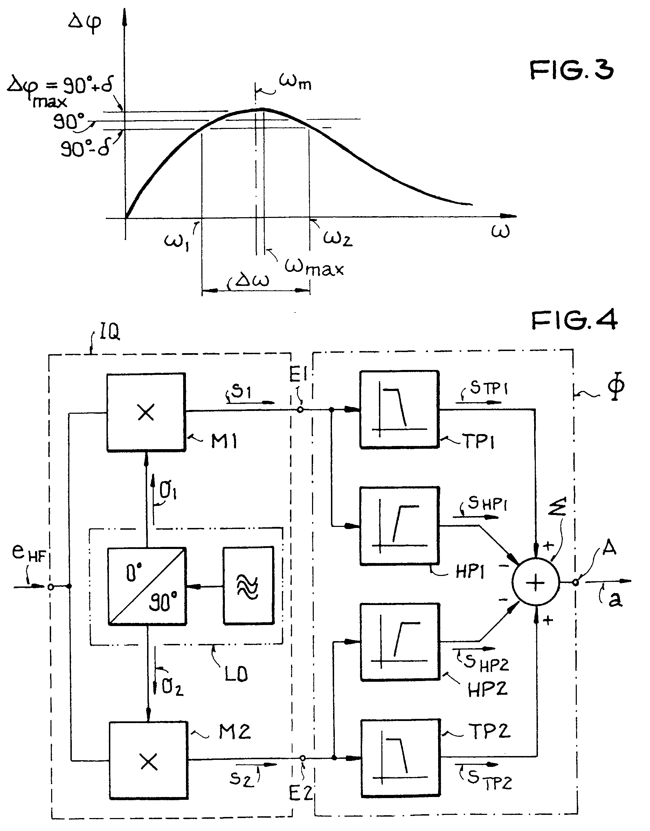

annimmt. Dieser Maximalwert $\Delta\varphi_{Max}$ wird gemäß Figur 3 derart gewählt, daß er um einen vorgegebenen Phasenfehler $\delta$ größer ist als 90°. Der Phasenfehler $\delta$ definiert dann einen durch die Kreisfrequenzen $\omega_1$, $\omega_2$ begrenzten Frequenzbereich $\omega_1...\omega_2$, in welchem die Phasendifferenz $\Delta\varphi$ um höchstens den Phasenfehler $\delta$ von 90° abweicht. Die Bandmitte $\omega_m$ dieses Frequenzbereiches $\omega_1...\omega_2$ wird derart gewählt, daß die Spektren der Zweigsignale $s_1$, $s_2$ -es handelt sich hierbei um bandbegrenzte Signale - innerhalb dieses Frequenzbereiches $\omega_1...\omega_2$ liegen. Obwohl die Bandbreite $\Delta\omega$ und die Bandmitte $\omega_m$ durch die Zeitkonstanten $\tau_1$, $\tau_2$ festgelegt werden, sind produktionsbedingte Schwankungen der Zeitkonstanten $\tau_1$, $\tau_2$ in der Regel unkritisch, da selbst für geringe Phasenfehler $\delta$ das Verhältnis Bandbreite $\Delta\omega$ zu Bandmitte $\omega_m$ relativ groß ist, beispielsweise 52% für $\delta$ = 1° oder 80% für $\delta$ = 2,5°, was für die Spektren bandbegrenzter Signale wie die Zweigsignale $s_1$, $s_2$ üblicherweise nicht zutrifft. Die Spektren der Zweigsignale $s_1$, $s_2$ müssen daher nicht genau in der Mitte des Frequenzbereichs $\omega_1...\omega_2$ liegen, um einen kleineren Phasenfehler als $\delta$ zu gewährleisten. Ein Abgleich der Zeitkonstanten $\tau_1$, $\tau_2$ zur Einstellung der Bandmitte $\omega_m$ und Bandbreite $\Delta\omega$ ist infolgedessen nicht erforderlich.

Die Schaltungsanordnung aus Figur 2 läßt sich gemäß Figur 4 zur unterdrückung von in einem Mischer IQ erzeugten Spiegelfrequenzen einsetzen. Der Mischer IQ ist als sogenannter I/Q-Demodulator ausgebildet, d. h. er weist zwei gleichartige Mischstufen M1, M2 auf, die durch ein bandbegrenztes Eingangssignal $e_{HF}$ sowie durch je eines von zwei Oszillatorsignalen $o_1$, $o_2$ angesteuert sind. Die Ausgänge der Mischstufen M1, M2 sind mit je einem der Eingänge $E_1$, $E_2$ der Phasenschieberanordnung $\Phi$ verbunden. Infolgedessen wird in der ersten Mischstufe M1 durch Mischung des Eingangssignals $e_{HF}$ mit dem ersten Oszillatorsignal $o_1$ das erste Zweigsignal $s_1$ und in der zweiten Mischstufe M2 durch Mischung des Eingangssignals $e_{HF}$ mit dem zweiten Oszillatorsignal $o_2$ das zweite Zweigsignal $s_2$ erzeugt. Die Oszillatorsignale $o_1$, $o_2$ werden dabei mittels eines Zweiphasenoszillators LO erzeugt und sind in der Frequenz $f_{LO}$ gleich und in der Phase gegeneinander um 90° versetzt.

Das Eingangssignal $e_{HF}$ ist auf eine hochfrequente Trägerwelle moduliert, deren Frequenz um einen bestimmten Betrag $\Delta f$ von der Frequenz $f_{LO}$ der Oszillatorsignale $o_1$, $o_2$ verschieden ist, so daß eine entsprechende Differenzfrequenz $f_D = f_{LO} - \Delta f$ und Summenfrequenz $f_S = f_{LO} + \Delta f$ am Ausgang der Mischstufen M1, M2 erscheint. Die eine dieser Frequenzen stellt dabei, je nachdem, ob die Schaltungsanordnung zur Abwärts- oder Aufwärtsmischung eingesetzt wird, eine gewünschte Nutzfrequenz und die andere eine unerwünschte Spiegelfrequenz dar.

Infolge des 90°-Phasenversatzes zwischen den Oszillatorsignalen $o_1$, $o_2$ sind auch die der Differenzfrequenz $f_D$ entsprechenden Signalanteile der Zweigsignale $s_1$, $s_2$ gegeneinander um 90° phasenversetzt. Gleiches gilt, jedoch mit entgegengesetztem Vorzeichen, auch für die der Summenfrequenz $f_S$ entsprechenden Signalanteile der Zweigsignale $s_1$, $s_2$. Da die Phasenschieberanordnung $\Phi$ eine zusätzliche Phasenverschiebung von 90° zwischen den Zweigsignalen $s_1$, $s_2$ bewirkt, werden bei geeignet gewähltem Vorzeichen dieser Phasenverschiebung in der Summationseinheit $\Sigma$ die der Nutzfrequenz entsprechenden Signalanteile der Zweigsignale $s_1$, $s_2$ gleichphasig addiert, die der Spiegelfrequenz entsprechenden Signalanteile der Zweigsignale $s_1$, $s_2$ hingegen gegenphasig addiert, was zur Auslöschung führt.

Die gesamte Schaltungsanordnung ist auf einen Halbleiterchip integriert, so daß eine möglichst gleich große Verstärkung des Eingangssignals $e_{HF}$ in beiden Signalzweigen gewährleistet ist. Diese in beiden Signalzweigen übereinstimmende Verstärkung ist zusammen mit einem geringen Phasenfehler der Phasenschieberanordnung $\Phi$ die Voraussetzung für eine wirkungsvolle Unterdrückung der Spiegelfrequenzen.

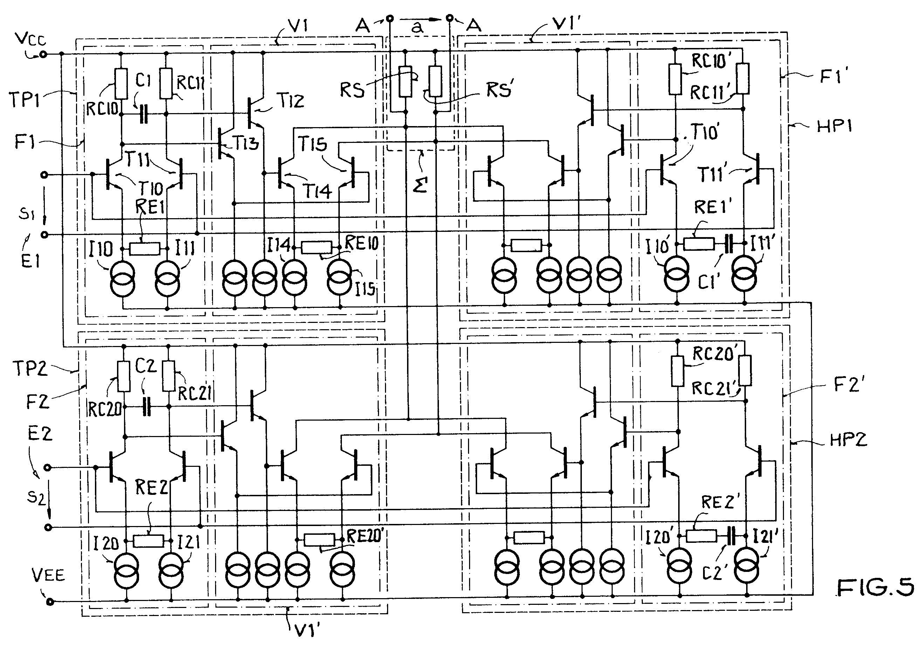

Gemäß Figur 5 weisen die Tiefpaßfilter TP1, TP2 und Hochpaßfilter HP1, HP2 jeweils differentielle Eingänge und Ausgänge auf. Hierdurch werden Gleichspannungsoffsets und Drifterscheinungen weitgehend vermieden. Das Tiefpaßfilter TP1 setzt sich aus einer Filterstufe F1 mit nachgeschalteter Verstärkerstufe V1 zusammen.

Die Filterstufe F1 weist zwei Transistoren T10, T11 auf, deren Emitter über den Emitterwiderstand RE1 miteinander und jeweils über eine der Stromquellen I10 bzw. I11 mit einem beispielsweise auf einem Bezugspotential liegenden ersten Versorgungsanschluß VEE verbunden sind und deren Kollektoren über den Kondensator C1 miteinander und jeweils über einen der beiden gleich großen Kollektorwiderständen RC10 bzw. RC11 mit einem zweiten Versorgungsanschluß VCC, an dem für ein Betriebspotential anliegt, verbunden sind. Die Basen der Transistoren T10, T11 bilden dabei den mit dem Eingang E1 verbundenen differentiellen Filtereingang, dem das erste Zweigsignal $s_1$ als Ein-

gangsspannung zugeführt wird, und die Kollektoren den differentiellen Ausgang der Filterstufe F1. Für die Zeitkonstante dieser Filterstufe gilt $\tau_{TP1}$ = 2 • RC10 • C1 .

Die Verstärkerstufe V1 weist eine Differenzverstärkerstufe mit zwei Transistoren T14, T15 auf, deren Emitter über einen Emitterwiderstand RE10 miteinander und über je eine der Stromquellen I14 bzw. I15 mit dem ersten Versorgungsanschluß VEE verbunden sind und deren Basen über je einen Emitterfolger T12 bzw. T13 mit jeweils einem von zwei Anschlüssen verbunden sind, welche den mit dem Filterausgang der Filterstufe F1 verbundenen differentiellen Eingang der Verstärkerstufe V1 bildenden. Der differentielle Ausgang der Verstärkerstufe V1 - die Kollektoren der Transistoren T14, T15 - sind an die Summationseinheit $\Sigma$ angeschlossen.

Letztere weist zwei gleiche Summationswiderstände RS, RS' auf, die jeweils mit einem Anschluß an den zweiten Versorgungsanschluß VCC und mit dem jeweils anderen Anschluß an je einen von zwei Summationsknoten angeschlossen sind, wobei die Summationsknoten sowohl als differentieller Schaltungsausgang A als auch als differentielle Eingänge der Summationseinheit $\Sigma$ fungieren. In den Summationswiderständen werden die als Ströme von den Filtern TP1, TP2, HP1, HP2 bereitgestellten gefilterten Zwischensignale vorzeichenbehaftet summiert. Das Ausgangssignal a entspricht dann der zwischen den Anschlüssen des Schaltungsausgangs A anstehenden Spannung.

Das erste Hochpaßfilter HP1 weist ebenso wie das Tiefpaßfilter HP1 eine Filterstufe F1' und eine dieser nachgeschaltete Verstärkerstufe V1' auf. Die Filterstufe F1' unterscheidet sich dabei von der Filterstufe F1 lediglich in ihrem Emitterwiderstand RE1' und ihrem Kondensator C1'. Letzterer ist nicht zwischen die Kollektoren der Transistoren T10', T11' sondern in Reihe zum Emitterwiderstand RE1' zwischen die Emitter dieser Transistoren T10', T11' geschaltet. Für die Zeitkonstante der Filterstufe F1' gilt die Beziehung $\tau_{HP1}$ = 2 • RE1'·C1'. Um gleich große Zeitkonstanten $\tau_{TP1}$, $\tau_{HP1}$ zu erhalten, müssen die Verhältnisse C1/C1' und RC10/RE1' gleich sein, was in integrierten Schaltungen mit hoher Genauigkeit erreichbar ist. Aufgrund gleich großer Emitterwiderstände RE1' und RE1, gleich großer Kollektorwiderstände RC10, RC11, RC10' und RC11' und gleich ausgeführter Stromquellen I10, I11, I10' und I11' weisen die beiden Filterstufen F1, F1' auch gleiche Verstärkungsfaktoren auf.

Die Verstärkerstufen V1, V1' sind identisch ausgeführt, so daß auch die Verstärkungsfaktoren der gesamten Filter TP1, HP1 gleich sind. Das negative Vorzeichen bei der Addition in der Summationseinheit $\Sigma$ erhält man dabei durch die Verschaltung, indem die Anschlüsse des differentiellen Ausgangs der Verstärkerstufe V1' miteinander vertauscht werden.

Die Tiefpaßfilter TP1, TP2 und die Hochpaßfilter HP1, HP2 unterscheiden sich jeweils lediglich in den werten ihrer die Zeitkonstanten bestimmenden Kondensatoren C1 und C2 bzw. C1' und C2'. Auch beim zweiten Tiefpaßfilter TP2 und zweiten Hochpaßfilter HP2 werden das Kapazitätsverhältnis C2/C2' und das Widerstandsverhältnis RC20/RE2', welches aufgrund gleich großer Kollektorwiderstände RC10, RC11, RC10', RC11', RC20, RC21, RC20', RC21' und gleich großer Emitterwiderstände RE1, RE1', RE2, RE2' gleich dem Verhältnis RC10/RE1' ist, gleich groß gewählt, um Gleichheit in bezug auf die Zeitkonstanten $\tau_{TP2}$, $\tau_{HP2}$ herbeizuführen.

## Patentansprüche

1. Integrierte Phasenschieberanordnung, die in einem ersten Signalzweig ein erstes Tiefpaßfilter (TP1) und ein erstes Hochpaßfilter (HP1) mit gleich großen Zeitkonstanten ($\tau_{TP1}$, $\tau_{HP1}$) und gleich großen Verstärkungsfaktoren ($K_{TP1}$, $K_{HP1}$) aufweist, wobei das erste Tiefpaßfilter (TP1) und das erste Hochpaßfilter (HP1) eingangsseitig miteinander und ausgangsseitig mit einer Summationseinheit ($\Sigma$) verbunden sind.

2. Integrierte Phasenschieberanordnung nach Anspruch 1, dadurch gekennzeichnet, daß sie in einem zweiten Signalzweig ein zweites Tiefpaßfilter (TP2) und ein zweites Hochpaßfilter (HP2) mit gleich großen Zweitkonstanten ($\tau_{TP2}$, $\tau_{HP2}$) und gleich großen Verstärkungsfaktoren ($K_{TP2}$, $K_{HP2}$) aufweist, wobei das zweite Tiefpaßfilter (TP2) und das zweite Hochpaßfilter (HP2) eingangsseitig miteinander und ausgangsseitig mit der Summationseinheit ($\Sigma$) verbunden sind.

3. Integrierte Phasenschieberanordnung nach Anspruch 2, dadurch gekennzeichnet, daß die Verstärkungsfaktoren ($K_{TP1}$, $K_{HP1}$, $K_{TP2}$, $K_{HP2}$) der Tiefpaßfilter (TP1, TP2) und Hochpaßfilter (HP1, HP2) gleich sind und die Zeitkonstanten ($\tau_{TP1}$, $\tau_{TP2}$, $\tau_{HP1}$, $\tau_{HP2}$) der Tiefpaßfilter (TP1, TP2) und der Hochpaßfilter (HP1, HP2) derart gewählt sind, daß die Differenz ($\Delta\varphi$) der Phasenverschiebung ($\varphi_1$, $\varphi_2$) in den beiden Signalzweigen bei einer vorgegebenen Frequenz ($f_{Max}$) maximal ist.

4. Integrierte Phasenschieberanordnung nach Anspruch 3, dadurch gekennzeichnet, daß der Maximalwert der Differenz ($\Delta\varphi$) der Phasenverschiebung ($\varphi_1$, $\varphi_2$) in den beiden Signalzweigen um einen vorgegebenen Phasenfehler ($\delta$) größer ist als 90°.

5. Integrierte Phasenschieberanordnung nach einem der vorherigen Ansprüche, dadurch gekennzeichnet, daß das erste Tiefpaßfilter (TP1) eine Filterstufe (F1) mit folgenden Schaltungsteilen aufweist:

- zwei Transistoren (T10, T11), die mit ihren Basen einen mit dem Eingang des ersten Tiefpaßfilters (TP1) verbundenen differentiellen Filtereingang der Filterstufe (F1) und mit ihren Kollektoren einen mit dem Ausgang des ersten Tiefpaßfilters (TP1) verbundenen differentiellen Filterausgang der Filterstufe (F1) bilden,

- zwei die Emitter dieser Transistoren (T10, T11) mit einem ersten Versorgungsanschluß (VEE) verbindende Stromquellen (I10, I11),

- zwei die Kollektoren dieser Transistoren (T10, T11) mit einem zweiten Versorgungsanschluß (VCC) verbindende Kollektorwiderständen (RC10, RC11),

- einen die Emitter dieser Transistoren (T10, T11) miteinander verbindenden Emitterwiderstand (RE1)

- und einen die Kollektoren dieser Transistoren (T10, T11) miteinander verbindenden Kondensator (C1).

6. Integrierte Phasenschieberanordnung nach einem der vorherigen Ansprüche, dadurch gekennzeichnet, daß das erste Hochpaßfilter (HP1) eine Filterstufe (F1') mit folgenden Schaltungsteilen aufweist:

- zwei Transistoren (T10', T11'), die mit ihren Basen einen mit dem Eingang des ersten Hochpaßfilters (HP1') verbundenen differentiellen Filtereingang der Filterstufe (F1') und mit ihren Kollektoren einen mit dem Ausgang des ersten Hochpaßfilters (TP1') verbundenen differentiellen Filterausgang der Filterstufe (F1') bilden,

- zwei die Emitter dieser Transistoren (T10', T11') mit einem ersten Versorgungsanschluß (VEE) verbindende Stromquellen (I10', I11'),

- zwei die Kollektoren dieser Transistoren (T10', T11') mit einem zweiten Versorgungsanschluß (VCC) verbindende Kollektorwiderständen (RC10', RC11'),

- und eine die Emitter dieser Transistoren (T10', T11') miteinander verbindende Reihenschaltung aus einem Emitterwiderstand (RE1') und einem Kondensator (C1').

7. Integrierte Phasenschieberanordnung nach Anspruch 6, dadurch gekennzeichnet, daß das zweite Tiefpaßfilter (TP2) in gleicher Art wie das erste Tiefpaßfilter (TP1) und das zweite Hochpaßfilter (HP2) in gleicher Art wie das erste Hochpaßfilter (HP1) ausgebildet sind.

8. Integrierte Phasenschieberanordnung nach einem der Ansprüche 5 bis 7, dadurch gekennzeichnet, daß die Kollektorwiderstände (RC10, RC11, RC10', RC11', RC20, RC21, RC20', RC21') gleich ausgeführt sind, die Emitterwiderstände (RE1, RE1', RE2, RE2') gleich ausgeführt sind und die Stromquellen (I10, I11, I10', I11', I20, I21, I20', I21') gleich ausgeführt sind.

9. Integrierte Phasenschieberanordnung nach Anspruch 8, dadurch gekennzeichnet, daß das Verhältnis (C1/C1') des Kapazitätswertes des Kondensators (C1) aus der Filterstufe (F1) des ersten Tiefpaßfilters (TP1) zum Kapazitätswert des Kondensators (C1') aus der Filterstufe (F1') des ersten Hochpaßfilters (HP1) gleich dem Verhältnis des Widerstandswertes eines der Kollektorwiderstände (RC10, RC11, RC10', RC11', RC20, RC21, RC20', RC21') zum Widerstandswert eines der Emitterwiderstände (RE1, RE1', RE2, RE2') ist.

10. Integrierte Phasenschieberanordnung nach Anspruch 9, dadurch gekennzeichnet, daß das Verhältnis (C2/C2') des Kapazitätswertes des Kondensators (C2) aus der Filterstufe (F2) des zweiten Tiefpaßfilters (TP2) zum Kapazitätswert des Kondensators (C2') aus der Filterstufe (F2') des zweiten Hochpaßfilters (HP2) gleich dem Verhältnis des Widerstandswertes eines der Kollektorwiderstände (RC10, RC11, RC10', RC11', RC20, RC21, RC20', RC21') zum Widerstandswert eines der Emitterwiderstände (RE1, RE1', RE2, RE2') ist.

11. Integrierte Phasenschieberanordnung nach einem der Ansprüche 5 bis 10, dadurch gekennzeichnet, daß die Tiefpaß- und Hochpaßfilter (TP1, TP2, HP1, HP2) jeweils eine die jeweilige Filterstufe (F1, F1', F2, F2') mit der Summationseinheit ($\Sigma$) verbindende Verstärkerstufe (V1, V1', V2, V2') aufweist.

12. Verwendung der integrierten Phasenschieberanordnung nach einem der vorherigen Ansprüche zur Unterdrückung von in einem Mischer (IQ) erzeugten Spiegelfrequenzen.

FIG. 1

FIG. 2

8

FIG.3

FIG.4

9

FIG.5